# EUROPEAN PATENT SPECIFICATION

(11) **EP 0 405 871 B1**
(45) Date of publication and mention of the grant of the patent: **08.09.1999**
(21) Application number: 90306893.0
(22) Date of filing: 25.06.1990
(51) Int. Cl.: H01L 23/495, H01L 23/58

(54) **Balanced capacitance lead frame for integrated circuits**
Anschlussrahmen mit ausgeglichener Kapazität für integrierte Schaltungen
Cadre de connexion à capacité équilibrée pour circuits intégrés

(30) Priority: 30.06.1989 US 373742
(43) Date of publication of application: 02.01.1991
(60) Divisional application: 98122512.1
(73) Proprietor: TEXAS INSTRUMENTS INCORPORATED, Dallas Texas 75265 (US)
(72) Inventor: Lamson, Michael A., Westminster, Texas 75096 (US); Heinen, Katherine G., Dallas, Texas 75230 (US)
(74) Representative: Abbott, David John

(56) References cited:
- US-A- 4 684 975
- PROCEEDINGS OF THE IEEE 1988 ELECTRONIC COMPONENTS CONFERENCE, 1988 New York, US pages 552-557; W.C. Ward: "Volume production of unique plastic surface-mount modules for the IBM 80-ns 1-Mbit DRAM chip by area wire bond techniques"
- PATENT ABSTRACTS OF JAPAN vol. 10, no. 347 (E-457)(2403) 21 November 1986 & JP-A-61 150 246 (FUJITSU) 08 July 1986
- PROCEEDINGS OF THE 18TH EUROPEAN MICROWAVE CONFERENCE, Turnbridge Wells, GB pages 222-227; T. Razban et al.: "Time domain performance on advanced packaging for high speed ICs on GaAs"

## Description

### TECHNICAL FIELD OF THE INVENTION

This invention relates to integrated circuits, and more particularly relates to a lead frame having balanced capacitance for use with integrated circuitry packaging.

### BACKGROUND OF THE INVENTION

Various techniques have heretofore been used to package integrated circuits. For example, various configurations utilizing lead frames to connect integrated circuits have been developed, such as the flip chip design and the small outline J lead (SOJ) packaging techniques. In many of these prior techniques, the integrated circuit is mounted upon a pad provided by a lead frame, and wire bonds connect from the integrated circuit to conductive leads on the lead frame.

In US-A-4 684 975 there is disclosed a lead frame tape for bonding directly to integrated circuits.

The Proceedings of the 18th European Microwave Conference 1988, at pages 222-227, discloses a semiconductor device package having tapered leads. A mathematical method for analysing the propagation of signals along those lines is discussed.

The abstract for JP-61-150246 in the Patent Abstracts of Japan Vol. 10, No. 347, (E-457), (2043), discloses a semiconductor package in which the leads are wire bonded to the semiconductor device.

An integrated circuit packaging technique termed the lead on chip (LOC) technique has been developed. As described in the article entitled "Volume Production Of Unique Plastic Surface-Mount Modules For The IBM 80-ns 1-Mbit DRAM Chip By Area Wire Bond Techniques" by William C. Ward, published at the 38th European Components Conference in 1988, this technique disposes a lead frame over the active area of an integrated circuit. Adhesive insulating tape connects the lead frame over the integrated circuit, and wire bonds connect the circuit directly to the power buses on the lead frame or jumper over the power buses to conductive leads to provide the correct signal routing. The ability to jump wires over various lead frame leads provides significant advantages by allowing alterable package I/O without chip redesign, since the wires can readily be routed over various buses or leads similar to conventional wire bonding as done on direct chip attached circuit cards.

While prior packaging techniques have worked well in practice for many designs, with the advent of more complex and smaller scale integrated circuits, it has become important to obtain equal loading capacitances for the input leads on the integrated circuit package. The provision of equal capacitances for various conductive leads is particularly significant for LOC applications, since the lead frame is separated from the active integrated circuit by a layer of dielectric. The requirement of equal capacitances for the conductive input leads has also become more important with the advent of large dynamic random access memory (DRAM) circuits such as the 16 meg DRAM. In such circuits, it is important that each address line has the same loading capacitance as the adjacent line in order to enhance the operational speed of the DRAM. Moreover, a need has arisen in the LOC package technique to provide additional noise shielding, which is particularly important in LOC devices because of the non-uniform metal closely adjacently disposed to the integrated circuit.

A need has thus arisen for a lead frame and integrated circuitry packaging technique which provides equal capacitances to all lead conductors associated with the integrated circuitry, while maintaining a high degree of noise shielding thereto.

The present invention provides a lead-on-chip integrated circuit device having an integrated circuit chip and a plurality of elongate conductive leads extending in a spaced side-by-side relationship, each of said leads comprising a first part extending from a first side of said chip to provide external connections for signals of the chip, and a second part extending over and insulated from a major surface of the integrated circuit chip and adapted for connection to an active portion of the integrated circuit;
characterised in that
each of the plurality of leads has an area that is substantially identical to that of all other signal leads, so that the capacitances of said signal leads of the device are substantially identical.

The elongate conductive leads may be attached to the major surface of the integrated circuit chip by an insulating layer. A conductive layer may be disposed between the plurality of leads and the integrated circuit chip and be insulated from both, so as to provide noise shielding of said integrated circuit chip from the elongate conductive leads.

Each lead may have a trapezoidal mid-section of substantially identical geometric area to the other leads of the plurality over a portion of its length overlying the chip.

The integrated circuit device may include an elongate bus having a central portion disposed generally normal to the conductive leads. The bus may have an extension extending in a side-by-side relationship to the leads, said extension being arranged as a false neighbouring lead to an end one of said plurality of signal leads, thereby to maintain the same loading capacitance for said end lead as for the other leads of the plurality.

The central portion of the bus may run substantially the length of the integrated circuit chip.

The integrated circuit chip may comprise a dynamic random access memory.

### BRIEF DESCRIPTION OF THE DRAWINGS

For a more complete understanding of the present invention and the advantages thereof, reference is now made to the following descriptions taken in conjunction with the accompanying drawings, in which:
FIGURE 1 is a top view of the lead frame used in an example of the present invention;
FIGURE 2 is a perspective, exploded view of the lead frame used in an example of the invention showing the adhesive tape and integrated circuit;
FIGURE 3 is a top view of the lead frame used in an example of the invention showing the connection of the integrated chip thereunder;
FIGURE 4 is a top view of the lead frame used in an example of the invention showing wire bonds from portions of the integrated circuit to ones of the conductive leads of the lead frame;
FIGURE 5 is a side view of the completed integrated circuit package; and
FIGURE 6 is a perspective view, partially broken away, of a completed integrated circuit package utilizing the present invention.

### DETAILED DESCRIPTION OF THE INVENTION

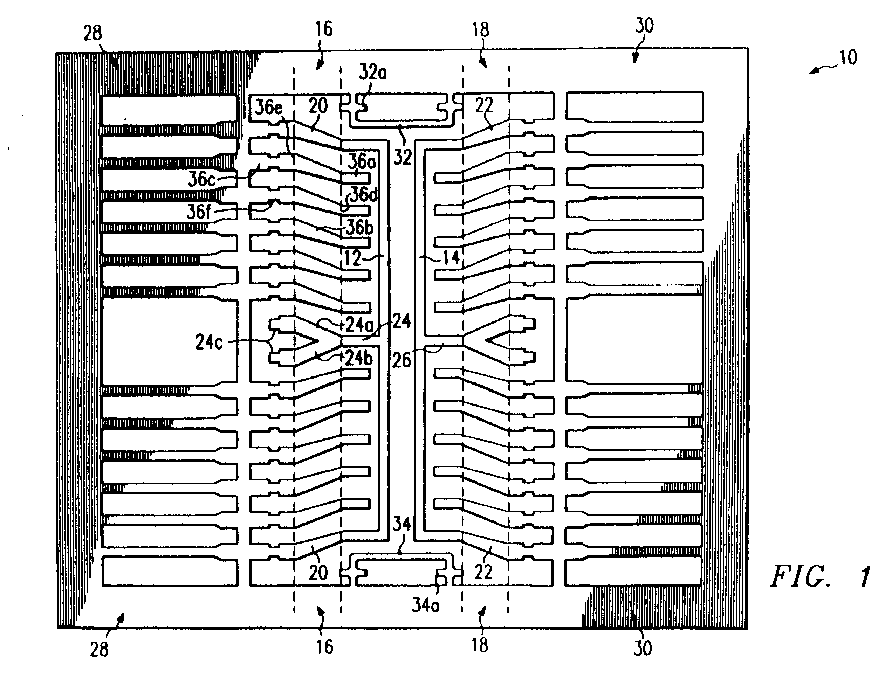

Referring to FIGURE 1, a lead frame 10 used in an example of the present invention comprises a metal sheet which may be formed of, for example, full hard temper CDA alloy 151 which may be approximately .008 in. (200 µm) in thickness and which may be spot plated in gold, silver, or the like. The metal sheet has a plurality of cutouts stamped therein to define a lead configuration. Specifically, the lead configuration comprises a pair of power buses 12 and 14 which comprise elongated parallel conductive lines suitable for receiving electrical power. A first group of conductive leads 16 is disposed generally normally to the power bus 12, with leads 16 being arranged in a side-by-side relationship. Similarly, a second group of conductive leads 18 is disposed generally normally to the power bus 14, with the leads 18 arranged in a side-by-side relationship. While it will be understood that different numbers of conductive leads may be provided in dependence upon the integrated circuitry, in the illustrated embodiment, ten conductive leads comprise the first group 16 and ten conductive leads comprise the second group 18. Conductive leads 16 and 18 are utilized to provide input and output signals to the associated integrated circuit.

End portions of power bus 12 extend normally to the center portion of the power bus 12 and are identified as dummy or false leads 20. Similarly, end portions of power bus 14 extend generally normally to the central portion of power bus 14 and are generally identified as dummy or false leads 22. Each of the power buses 12 and 14 also include center extensions 24 and 26. As will be subsequently described in greater detail, these center bus extensions 24 and 26 operate as dummy or false conductive leads to assist in maintaining equal capacitance of neighboring conductive leads.

An important aspect of the present invention is that each of the conductive leads 16 and 18 are formed with a substantially identical geometric configuration. In this way, each of the conductive leads 16 and 18 have substantially identical capacitances.

Cutouts in the lead frame sheet also define a first group 28 of lead extensions and a second group 30 of lead extensions. As will be subsequently described, these lead extensions 28 and 30 are partially cut or trimmed away during final assembly of the integrated circuit package. Support bars 32 and 34 are provided on opposite ends of the wire frame in order to provide added support to the encapsulated package.

Locking extensions 32a and 34a are provided to enable locking of the support bars 32 and 34 within the plastic encapsulation to ensure integrity of the package.

In order to better understand the inventive concept wherein equal capacitances are provided to each of the conductive leads, conductive lead 36 will now be described in greater detail. Lead 36 is comprised of three different sections. The first section 36a is spaced apart from and oriented normally to the central power bus 12. The second or middle portion 36b of the lead is angled away from normal to the power bus 12 and has a trapezoidal cross-sectional area. The third section 36c of the lead is disposed normally to the central power bus 12. As will be subsequently described, section 36a of the lead is used to receive wire bonding to an active portion of the integrated circuit located below the lead. Section 36c of the lead extends from the integrated circuit package and is used to make physical contact with exterior circuitry. Locking notches 36f are provided in the conductive lead 36 to enable secure locking of the conductive lead within the encapsulation plastic in subsequent encapsulation steps to be described.

An important aspect of the present invention is that each of the conductive leads 16 and 18 have substantially identical cross-sectional areas as lead 36. As may be seen from the drawings, each of the first sections of the leads which correspond to section 36a are rectangular and have the identical cross-sectional area. Similarly, each of the trapezoidal areas corresponding to section 36b have substantially identical cross-sectional areas. Preferably each of the mid sections of the conductive leads which form the trapezoidal areas have identical length upper and lower bases which form the trapezoidal area. Specifically, the base 36d of lead 36 is identical in length as the corresponding bases for all other conductive leads on the lead frame. Similarly, the base 36e forming the lower base of the trapezoidal area has an identical length as all other corresponding bases in the remaining conductive leads. It may also be seen that the heights of the trapezoidal areas of all the conductive leads 16 and 18 are the same. Since trapezoids with equal bases and equal heights have equal areas, the present invention provides an easy technique to ensure that all mid areas of the conductive leads are equal. Similarly, it may be seen that the areas of each of the third sections 36c of the conductive leads are identical. Since the geometrical areas of each of the conductive leads is identical, the capacitance of the leads will be found to be substantially identical.

The provision of the trapezoidal mid-sections of the conductive leads is advantageous as they enable the leads to diverge from normal to accommodate sufficient size external lead pads to ensure adequate electrical contact with exterior circuits. Specifically, it may be seen that the top five conductive leads forming group 16 diverge from normal in an upward angle, while the bottom five conductive leads forming group 16 diverge from normal at a downwardly oriented angle. Similarly, the first five conductive leads forming group 16 diverge from normal at an upward angle, while the bottom five leads diverge from normal at a downward angle. The unique geometry of the conductive leads enables this divergence without a change in geometrical area and resulting capacitance.

Also advantageous is the provision of the dummy or false leads 20 and 22 as well as the center bus extensions 24 and 26 which form dummy or false leads. Without these dummy or false leads, certain of the conductive leads of the invention could have differing capacitances than their neighbors, because such leads were not surrounded on both sides with identically shaped leads. With the provisions of the identically shaped dummy or false lead extensions 20-26 from the power buses 12 and 14, neighboring conductive leads may be provided with identical capacitances. For example, without dummy or false lead 20, conductive lead 36 would have only its lower neighbor conductive lead closely associated therewith. However, with the provision of the upper dummy lead 20, which is provided with an identical shape to conductive lead 36, lead 36 is surrounded on both sides by identical leads.

Similarly, the center bus extensions 24 and 26 operate to provide equal capacitance to their neighbor leads. As may be seen, extensions 24 and 26 are of identical construction and each have a Y configuration. Referring specifically to extension 24, the Y configuration includes a leg 24a and 24b. It may be seen that each of the legs 24a and 24b are identical in construction and that they have substantially the same trapezoidal configuration as the mid portions of the two adjacent conductive leads. The legs 24a and 24b do not extend as far outwardly from power bus 12 as do the conductive leads, since the legs 24a and 24b will not extend outside of the hermetically sealed package. Locking notches 24c are provided in each of the legs in order to maintain the substantially identical geometric area, to ensure that the neighboring conductive leads see a substantially identical conductive mass to ensure that substantially identical capacitance is maintained in those adjacent conductive leads.

The Y shaped configuration of the extensions 24 and 26 enable equal capacitance to be provided to the conductive leads of the invention, even with the diverging orientation of the leads as previously described. In some cases, a small capacitance imbalance may be initially provided because the geometries of the legs 24a and 24b are not identical with those of the neighboring conductive leads. However, this imbalance may be nullified by carefully selecting the length of the legs 24a and 24b to provide the desired exact capacitance balance.

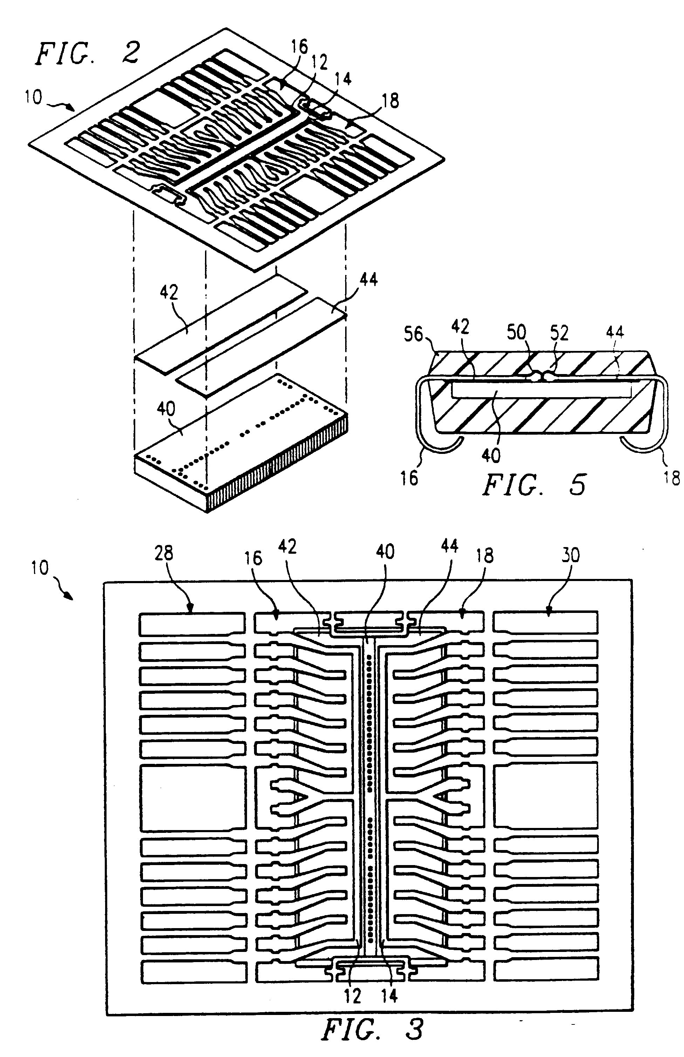

FIGURE 2 illustrates a perspective exploded view of the connection of the lead frame 10 to an integrated circuit 40. Integrated circuit 40 may comprise any suitable type of integrated circuit for use with a lead frame 10, but it has been found particularly advantageous to use the present lead frame with integrated circuits such as DRAMs. In particular, because of the extreme complexity and small dimensions associated with circuits such as the 16 meg DRAM, the present invention is particularly adaptable for use with such complex circuits.

Two pieces of double-sided adhesive 42 and 44 are disposed over the top of the integrated circuit 40 and attach the lead frame 10 over the top of the integrated circuit 40. It is this configuration which leads to the description of the lead over chip (LOC). The use of the double-sided adhesive 42 and 44 is known, and the adhesive may comprise, for example, a double-sided thermosetting epoxy adhesive coated polyimide film which also acts as an active barrier. The integrated circuit 40 and the lead frame 10 form a self supporting structure. The power buses 12 and 14 and the conductive leads 16 and 18 provide for highly efficient central distribution of voltage, ground and control signals. The power buses 12 and 14 and conductive leads 16 and 18 are laminated directly over the primary heat generating circuits of the integrated circuit, thus optimizing heat dissipation.

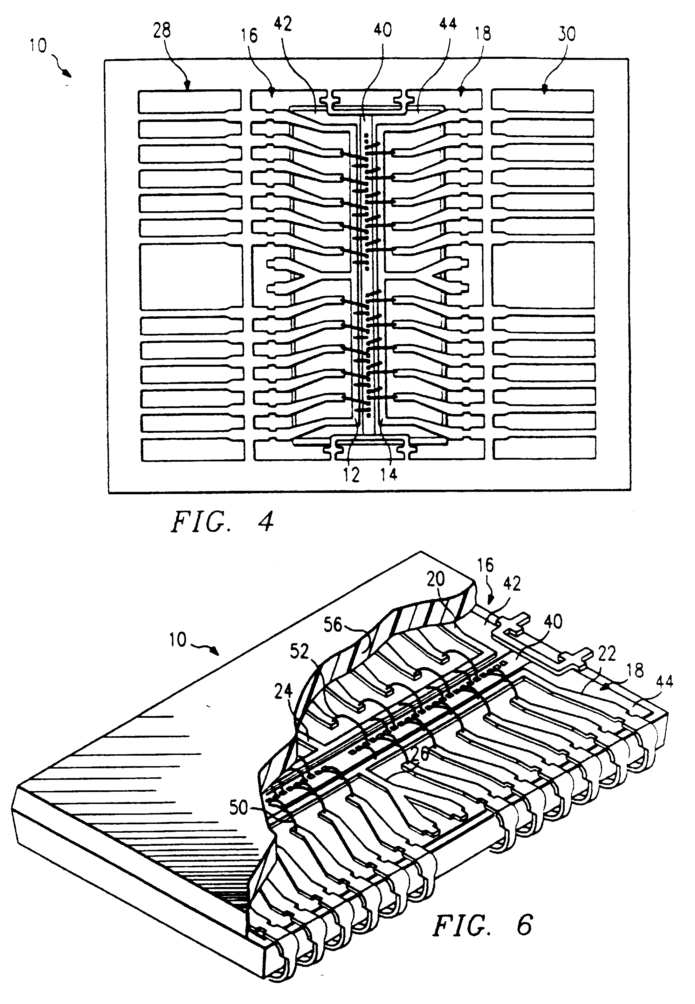

When the lead frame 10 is affixed over the integrated circuit 40 in the manner shown in FIGURE 2, the resulting configuration will appear as shown in FIGURE 3, which comprises a top view of the finished subassembly. The power buses 12 and 14 comprise spaced apart parallel conductive buses which run along the middle of the integrated circuit 40. The adhesives 42 and 44 are spaced apart such that active portions of the integrated circuit 40 are exposed for bonding to the conductive leads of the invention as will be subsequently described. Again, the identical configuration of the conductive leads 16 and 18 may be seen, which provides the substantially identical capacitance provided by the invention.

Referring to FIGURES 2 and 3, another important aspect of the invention may be understood. Because of the irregularity of metal disposed over the integrated circuit 40, certain circuits within the integrated circuit 40 are subject to noise. It has been determined that the provision of a conductive layer associated with the adhesives 42 and 44 serves to substantially shield the integrated circuit from the non-uniform leads of the lead frame. A layer of conductive metal such as copper may then be placed on the sides of the adhesives 42 and 44 away from the integrated circuit 40. Adhesive may then be deposited over the metallic layer for connection to the underside of the lead frame 10. Substantial noise shielding is thus provided by the conductive layer associated with the bonding adhesives 42 and 44.

After the lead frame 10 has been connected to the integrated circuit 40 by adhesives 42 and 44, the subassembly is laminated under suitable temperature and pressure conditions and is then oven cured to fully cross-link the adhesive.

FIGURE 4 illustrates the next stage of assembly of the present invention wherein high speed thermosonic gold ball wire bonding is accomplished. While it will be understood that various types of wire bonding may be utilized with the invention, bonding using 0.001 in (25 µm) diameter gold wire has been successfully accomplished. As noted, the gold wire bonds selected portions of the integrated circuit 40 to selected portions of the power buses 12 and 14 and to the conductive leads 16 and 18. For example, wire lead 50 connects the integrated circuit to power bus 12, while wire lead 52 bonds the integrated circuit to one of the conductive leads 16. It will be understood that the wire bonding scheme will vary depending upon the particular configuration of the integrated circuit 40 used with the invention.

After testing of the wire bond ball connections by suitable shear and pull tests, transfer molding of the invention with a molding compound is conducted. While different molding compounds are usable with the present invention, a Novolac epoxy mold compound has been found to work well to encapsulate the entire integrated circuit device. Because of the complexity of the circuitry, low stress mold techniques are utilized. The molded device is then cured, deflashed and lead preparation is conducted on the external leads. The leads are then trimmed and formed by bending to produce the nearly finished product depicted in FIGURES 5 and 6.

FIGURE 5 illustrates an end view of the substantially finished product wherein the integrated circuit 40 may be seen encapsulated within a plastic body 56. Conductive leads 16 and 18 are shown extending from over the integrated circuit 40 and adhesives 42 and 44 to external of the molded plastic body 56. Leads 16 and 18 are bent for suitable physical and electrical contact with external circuitry. Wire bonds 50 and 52 may be seen connecting portions of the integrated circuit 40 with the leads 16 and 18.

FIGURE 6 illustrates in perspective a partially cut away view of the finished semiconductor package. The plastic encapsulation totally surrounds the integrated circuit 40 and all portions of the adhesives 42 and 44. FIGURE 6 illustrates clearly the side-by side symmetrical relationships of the lead conductors 16 and 18. It may be seen that the geometry and shape of each of the twenty conductive leads 36 and 38 are substantially identical to one another and that the trapezoidal middle section of the conductive leads enables the leads to diverge from one another while yet maintaining identical geometry. It may also be seen how the dummy or false leads 20-22 act to balance the capacitance of the end conductive leads. FIGURE 6 further illustrates the center bus extensions 24 and 26 and shows how the geometry of the Y shaped legs of the extensions 24 and 26 operate as dummy or false leads to balance the capacitance of the diverging neighboring conductive leads.

Again, the provision of the metallic coating on the adhesive tapes 42 and 44 tends to isolate the elements on the integrated circuit 42 from electrical disturbances in the lead frame 10. The resultant symmetry of the present lead frame design and the addition of the dummy or false leads from the power buses improves the thermal dissipation and lowers thermal or temperature gradients of the packaging system, thus allowing a greater number of and more evenly distributed thermal paths.

By balancing the capacitance in the manner described above, the equality of loading capacitance between signal leads is maintained at all lead frame heights above the surface of the integrated circuit 42. In other words, it is possible to provide the conductive leads 16 and 18 with upsteps or downsteps at any arbitrary line parallel to the edge of the integrated circuit package. In this manner, the conductive leads may be stepped up or down as needed in order to control the total loading capacitance of the package, while maintaining the equality of capacitance between the individual conductive leads. Moreover, the up or down setting of the leads enables accurate control of the thermal dissipation properties of the package and the stress distribution of the package. The provision of such up or down steps in the conductive leads while maintaining equal capacitance is not available with other designs due to the differing geometries of the neighboring leads.

When the device is fabricated to the stage indicated by FIGURE 6, additional lead finishing with eutectic lead solder dipping, singulation, marking, inspection test and burn-in are required to complete the final product for use.

While it will be understood that the actual dimensions of the lead frame 10 of the present invention will vary in dependence upon its intended use, it has been found that a typical width of section 36a (FIGURE 1) may be 0.015 in. (380 µm) while the width of the third section 36c of the conductive lead may comprise .025 in. (640 µm). The total length of a conductive lead 16 or 18 in the preferred embodiment may be 0.3 in. (7.6 mm). The above-noted dimensions have been found to adequately accommodate an integrated package having the dimensions 340 x 660mm.

Although the present invention has been described in detail, it should be understood that various changes, substitutions and alterations can be made herein without departing from the scope of the invention as defined by the appended claims.

## Claims

1. A lead-on-chip integrated circuit device having an integrated circuit chip (40) and a plurality of elongate conductive leads (16,18) extending in a spaced side-by-side relationship, each of said leads comprising a first part extending from a first side of said chip to provide external connections for signals of the chip, and a second part extending over and insulated from a major surface of the integrated circuit chip and adapted for connection to an active portion of the integrated circuit;
CHARACTERISED IN THAT
each of the plurality of leads (16,18) has an area that is substantially identical to that of all other signal leads, so that the capacitances of said signal leads of the device are substantially identical.

2. A device according to claim 1, wherein the elongate conductive leads (16,18) are attached to the major surface of the integrated circuit chip by an insulating layer (40,42).

3. A device according to claim 2 further comprising:
a conductive layer disposed between the plurality of leads and the integrated circuit chip and insulated from both, so as to provide noise shielding of said integrated circuit chip from the elongate conductive leads.

4. A device according to claim 1, claim 2 or claim 3, wherein each lead has a trapezoidal mid-section of a substantially identical geometric area to the other leads of the plurality over a portion of its length overlying the chip.

5. A device according to any preceding claim further including:
an elongate bus (12,14) overlying the chip (40), the bus having a central portion disposed generally normal to said conductive leads.

6. A device according to claim 5 further including:
an extension (20,22,24,26) from said bus (12,14) extending in a side-by-side relationship to said leads;
said extension being arranged as a false neighbouring lead to an end one of said plurality of signal leads thereby to maintain the same loading capacitance for said end lead as for the other leads of the plurality.

7. A device according to claim 5 or claim 6, wherein the central portion of said bus (12,14) runs substantially the length of said integrated circuit chip (40).

8. A device according to any one of the preceding claims, wherein said integrated circuit chip (40) comprises a dynamic random access memory.

## Patentansprüche

1. Integrierte Schaltungsvorrichtung mit Anschlußleitern auf dem Chip, die einen integrierten Schaltungschip (40) und mehrere längliche, leitfähige Anschlußleiter (16, 18) aufweist, die sich Seite an Seite im Abstand voneinander erstrecken, wobei jeder der Anschlußleiter einen ersten Teil, der sich von einer ersten Seite des Chips erstreckt, um externe Anschlüsse für Signale des Chips vorzusehen, sowie einen zweiten Teil aufweist, der sich über eine Hauptfläche des integrierten Schaltungschips erstreckt, dagegen isoliert ist und zum Anschluß an einen aktiven Abschnitt der integrierten Schaltung geeignet ist,
dadurch gekennzeichnet, daß jeder der mehreren Anschlußleiter (16, 18) eine Fläche aufweist, die im wesentlichen mit derjenigen aller anderen Signalanschlußleiter identisch ist, so daß die Kapazitäten der Signalanschlußleiter der Vorrichtung im wesentlichen identisch sind.

2. Vorrichtung nach Anspruch 1, bei welcher die länglichen, leitfähigen Anschlußleiter (16, 18) über eine Isolierschicht (40, 42) an der Hauptfläche der integrierten Schaltung befestigt sind.

3. Vorrichtung nach Anspruch 2, die ferner folgendes aufweist: eine leitfähige Schicht, die zwischen den mehreren Anschlußleitern und dem integrierten Schaltungschip angeordnet ist und gegen beide isoliert ist, um für eine Störungsabschirmung des integrierten Schaltungschips von den länglichen, leitfähigen Anschlußleitern zu sorgen.

4. Vorrichtung nach Anspruch 1, Anspruch 2 oder Anspruch 3, bei welcher jeder Anschlußleiter einen trapezförmigen Mittelabschnitt mit einer zu den anderen Anschlußleitern aus den mehreren im wesentlichen identischen geometrischen Fläche über einen Abschnitt seiner Länge aufweist, der über dem Chip liegt.

5. Vorrichtung nach einem der vorhergehenden Ansprüche, die ferner folgendes umfaßt:
einen länglichen Bus (12, 14), der über dem Chip (40) liegt, wobei der Bus einen zentralen Abschnitt aufweist, der allgemein senkrecht zu den leitfähigen Anschlußleitern angeordnet ist.

6. Vorrichtung nach Anspruch 5, die ferner folgendes umfaßt: eine Verlängerung (20, 22, 24, 26) von dem Bus (12, 14), die sich Seite an Seite zu den Anschlußleitern erstreckt,
wobei die Verlängerung als falscher benachbarter Anschlußleiter zu einem Endleiter aus den mehreren Signalanschlußleitern angeordnet ist, um dadurch die gleiche Lastkapazität für den Endanschlußleiter wie für die anderen Anschlußleiter aus den mehreren aufrechtzuerhalten.

7. Vorrichtung nach Anspruch 5 oder Anspruch 6,
bei welcher der zentrale Abschnitt des Busses (12, 14) im wesentlichen über die Länge des integrierten Schaltungschips (40) verläuft.

8. Vorrichtung nach einem der vorhergehenden Ansprüche,
bei welcher der integrierte Schaltungschip (40) einen dynamischen RAM beinhaltet.

## Revendications

1. Dispositif à circuit intégré de type à conducteurs sur puce ayant une puce à circuit intégré (40) et une pluralité de conducteurs allongés (16, 18) s'étendant espacés et côte à côte, chacun desdits conducteurs comprenant une première partie s'étendant d'un premier côté de ladite puce pour former des connexions externes pour les signaux de la puce, et une seconde partie s'étendant sur la majeure partie de la surface de la puce de circuit intégré et isolée par rapport à celle-ci et qui est à même d'assurer une connexion avec une partie active du circuit intégré,
caractérisé en ce que
chacun de la pluralité de conducteurs (16, 18) a une surface qui est sensiblement identique à celle de tous les autres conducteurs de signaux, de telle sorte que les capacités desdits conducteurs de signaux du dispositif soient sensiblement identiques.

2. Dispositif selon la revendication 1, dans lequel les conducteurs allongés (16, 18) sont fixés sur la majeure partie de la surface de la puce à circuit intégré par une couche isolante (40, 42).

3. Dispositif selon la revendication 2, comprenant par ailleurs :
une couche conductrice disposée entre la pluralité de conducteurs et
la puce à circuit intégré et isolée de ceux-ci, de manière à obtenir une protection de ladite puce à circuit intégré contre le bruit provenant des conducteurs allongés.

4. Dispositif selon la revendication 1, 2 ou 3, dans lequel chaque conducteur a une section centrale trapézoïdale d'une surface géométrique sensiblement identique à celle des autres conducteurs de la pluralité sur une partie de sa longueur chevauchant la puce.

5. Dispositif selon l'une quelconque des revendications précédentes, comprenant par ailleurs :
un bus allongé (12, 14) recouvrant la puce (40), le bus ayant une partie centrale disposée de manière générale normalement auxdits conducteurs.

6. Dispositif selon la revendication 5, comprenant par ailleurs :
une extension (20, 22, 24, 26) dudit bus (12, 14) s'étendant côte à côte avec lesdits conducteurs,
ladite extension étant agencée en conducteur de faux voisinage avec un conducteur terminal de ladite pluralité de conducteurs de signaux de manière à maintenir la même capacité de charge pour ledit conducteur terminal que pour les autres conducteurs de la pluralité.

7. Dispositif selon la revendication *5* ou 6, dans lequel la partie centrale dudit bus (12, 14) s'étend sensiblement sur la longueur de ladite puce à circuit intégré (40).

8. Dispositif selon l'une quelconque des revendications précédentes, dans lequel ladite puce à circuit intégré (40) comprend une mémoire à accès sélectif dynamique.
